# EUROPÄISCHE PATENTSCHRIFT

(11) **EP 2 781 024 B1**
(45) Veröffentlichungstag und Bekanntmachung des Hinweises auf die Patenterteilung: **22.01.2020**
(21) Anmeldenummer: 12797699.1
(22) Anmeldetag: 13.11.2012
(51) Int. Cl.: H03K 17/96

(54) **MÖBELSTÜCK MIT EINEM ELEKTRONISCHEN SCHALTELEMENT FÜR EIN VERKEHRSFLUGZEUG**
PIECE OF FURNITURE WITH AN ELECTRONIC SWITCHING ELEMENT FOR AN AIRLINER
MEUBLE COMPRENANT UN ÉLÉMENT DE COMMUTATION ÉLECTRONIQUE POUR AVION DE LIGNE

(30) Priorität: 14.11.2011 DE 102011086320
(43) Veröffentlichungstag der Anmeldung: 24.09.2014
(73) Patentinhaber: Lufthansa Technik AG, 22335 Hamburg (DE)
(72) Erfinder: WENDE, Gerko, 20251 Hamburg (DE); MUIRHEAD, Andrew, 22848 Norderstedt (DE)
(74) Vertreter: Müller Verweyen
(86) Internationale Anmeldenummer: PCT/EP2012/004716
(87) Internationale Veröffentlichungsnummer: WO 2013/072040

(56) Entgegenhaltungen:
- EP-A1- 2 048 781
- EP-A1- 2 337 225
- EP-A2- 2 385 630
- WO-A1-2005/101663
- WO-A2-2007/124754
- DE-A1-102008 018 616
- DE-A1-102009 001 412
- DE-A1-102010 010 806
- US-A1- 2009 090 611

## Beschreibung

Die Erfindung betrifft ein Möbelstück mit einem elektronischen Schaltelement für ein Verkehrsflugzeug mit den Merkmalen des Oberbegriffs des Anspruchs 1.

Möbelstücke in Verkehrsflugzeugen, insbesondere solche Möbelstücke, die in besonders aufwendig und speziell eingerichteten Kabinenausstattungen sogenannter "VIP-Flugzeuge" eingebaut werden, können mit elektronischen Schaltelementen ausgestattet sein. Beispielsweise können Tische, Stühle, Seitenkonsolen oder Regale elektronische Schaltelemente aufweisen.

Möbelstücke in VIP-Flugzeugen weisen üblicherweise eine Strukturschicht aus einer Leichtbauwabenkonstruktion und ein darüber angeordnetes Edelholzfurnier, welches durch eine Deckschicht (Lack oder Harz) versiegelt ist, auf.

Dabei werden die Schaltelemente, beispielsweise Schalter zum Ein- und Ausschalten von Leuchtmitteln, für den Fluggast möglichst einfach bedienbar auf der Oberfläche der Möbelstücke vorgesehen.

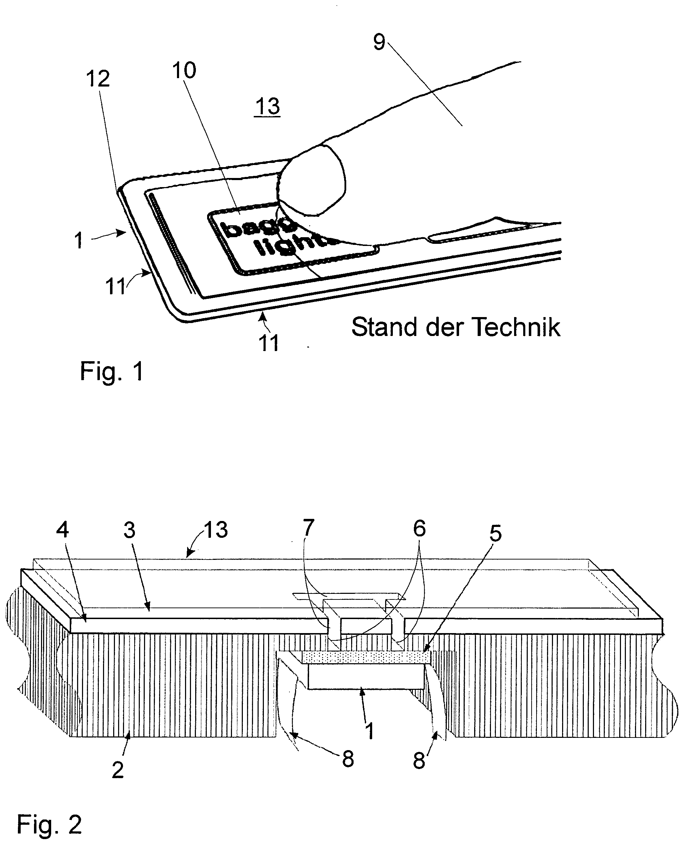

Ein solcher Schalter nach dem Stand der Technik ist in der später beschriebenen Figur 1 beispielhaft dargestellt.

Bei derartigen Schaltern, die üblicherweise in oder auf der Oberfläche von Möbeln in ausgefrästen Vertiefungen eingesetzt **sind, können** sich an Rändern und in Spalten Verschmutzungen ansammeln, die nur schwer gereinigt werden können.

Diese Verschmutzungen und die aufgrund des Schaltelementeinsatzes nicht vollständig plane Oberfläche, stören das ästhetische Gesamtbild und zusätzlich sind die elektrischen Elemente der Schalter gegenüber eindringenden Flüssigkeiten prinzipiell anfällig.

Insbesondere während des Fluges kann jedoch nicht ausgeschlossen werden, dass Flüssigkeit verschüttet wird und in vorhandene Spalte und/oder das Schaltelement eindringt. Daher müssen die elektrischen Schaltelemente mit besonderen Sicherheitsmechanismen ausgestattet werden, die die Komplexität des Gesamtsystems erhöhen und auch aufwendig sein können.

Aus der Druckschrift US 2009/090611 A1 ist ein kapazitativer berührungsempfindlicher Schalter bekannt, der durch eine LED beleuchtet ist, wobei die LED an einen Lichtleiter gekoppelt ist. Der Lichtleiter ist dabei hinter einer transparenten Abdeckung und zwischen zwei nichtleitenden Schichten angeordnet. Weiter ist aus der Druckschrift DE 10 2010 010 806 A1 eine Bedienvorrichtung bekannt, die einen Touchscreen aufweist, wobei auf dem Touchscreen verschiedene Bedienmenüs darstellbar sind. Durch die Anordnung mehrerer Sensoren benachbart zueinander, die einem einzigen Bildzeichen zugeordnet sind, können auch komplexere Schalter, wie z.B. Schieberegler, umgesetzt werden. Aus der Druckschrift DE 10 2009 001 412 A1 ist ein kapazitatives Anzeige- und Bedienelement bekannt. Zur Detektion einer Berührung oder Annäherung ist eine Sensor-Platine vorgesehen, der wiederum ein Leuchtmittel zugeordnet ist.

Aus der Druckschrift WO 2007/124754 A2 ist ein Möbelstück mit einem kapazitiven Schaltelement bekannt.

Der Erfindung liegt somit die Aufgabe zugrund, ein Möbelstück mit einem Schaltelement für ein Verkehrsflugzeug bereitzustellen, bei dem die beschriebenen Probleme nicht oder zumindest weniger stark auftreten.

Die Erfindung löst diese Aufgabe mit den Merkmalen des Anspruchs 1. Weitere bevorzugte Ausgestaltungen der Erfindung sind den Unteransprüchen, den Figuren sowie der zugehörigen Beschreibung zu entnehmen.

Zur Lösung der Aufgabe wird somit erfindungsgemäß ein Möbelstück mit einem elektronischen Schaltelement zur Steuerung einer Kabinenfunktion für ein Verkehrsflugzeug vorgeschlagen, wobei das Möbelstück eine Strukturschicht und eine oberhalb der Strukturschicht angeordnete Deckschicht aufweist, und wobei das elektronische Schaltelement als kapazitives Schaltelement ausgeführt ist und unterhalb der Deckschicht innerhalb und/oder unterhalb der Strukturschicht angeordnet ist.

Durch ein Ausführen des elektronischen Schaltelements als kapazitives Schaltelement, welches unterhalb der Deckschicht angeordnet ist, kann erreicht werden, dass die Deckschicht durchgängig und plan ausgeführt werden kann.

Die Deckschicht schützt die elektronischen und/oder elektrischen Komponenten des Schaltelements durchgängig vor etwaigen auf der Oberfläche verschütteten Flüssigkeiten. Es gibt keine Spalte oder Ränder, in denen sich Verschmutzungen sammeln können.

Erfindungsgemäß umfasst das Möbelstück ein Leuchtmittel, welches oberhalb des kapazitiven Schaltelements und unterhalb der Deckschicht angeordnet ist. Durch ein Leuchtmittel, welches oberhalb des kapazitiven Schaltelements angeordnet ist, kann die Position des kapazitiven Schaltelements präzise und intuitiv durch den Bediener, also beispielsweise der Fluggast, festgestellt werden. Das Leuchtmittel ist demnach vorzugsweise so ausgeführt, dass die Leuchtkraft ausreicht, um beim Betrachten des Möbelstücks den beleuchteten Bereich erkennen zu können. Es kann dadurch als Hintergrundbeleuchtung für den gewünschten Bereich dienen.

Erfindungsgemäß kann die Sichtbarkeit des Leuchtmittels dabei durch Aussparungen in der Strukturschicht oberhalb des Leuchtmittels verbessert werden. Das vom Leuchtmittel emittierte Licht muss dann nicht durch feste Bestandteile der Strukturschicht bzw. Teile der Strukturschicht hindurchstrahlen. Somit weist die Strukturschicht in bevorzugten Ausführungsformen der Erfindung oberhalb des Leuchtmittels eine oder mehrere Aussparungen auf.

Bei einem Möbelstück für eine besonders aufwendige (VIP)Kabinenausstattung kann der ästhetische Eindruck des Möbelstücks durch eine Zwischenschicht aufgewertet werden, die vorzugsweise zwischen Strukturschicht und Deckschicht angeordnet ist, und welche bevorzugt als Holzfurnier ausgeführt ist. Die Zwischenschicht kann dabei auf die gewünschten ästhetischen Ansprüche angepasst werden.

Die Zwischenschicht weist vorzugsweise ein Fensterelement auf, welches zumindest teilweise für sichtbares Licht transparent ist und oberhalb der Aussparungen der Strukturschicht angeordnet ist. Ähnlich wie die beschriebenen Aussparungen, ermöglicht das Fensterelement, dass das vom Leuchtmittel emittierte Licht gut sichtbar ist.

Das Fensterelement ist in einer entsprechenden Ausfräsung der Zwischenschicht angeordnet. Diese Ausfräsung bzw. das darin angeordnete Fensterelement und/oder die zuvor beschriebenen Aussparungen der Strukturschicht weisen vorzugsweise eine der zu steuernden Kabinenfunktion zuordenbare geometrische Form auf.

Beispielsweise kann eine geometrische Form gewählt werden, die einer Leselampe oder einer Tischlampe ähnelt, und so dem Fluggast suggeriert, dass das elektronische Schaltelement zur Steuerung eben der Beleuchtung des Tisches oder zur Steuerung der Leselampe vorgesehen ist.

Dadurch ist für den Fluggast sofort und einfach erkennbar, welche Kabinenfunktion durch das elektronische Schaltelement steuerbar ist. Gemeinsam mit dem Leuchtmittel ist die Position und die entsprechende Kabinenfunktion des elektronischen Schaltelements einfach zu erkennen und dadurch auch zu bedienen.

Die Deckschicht ist vorzugsweise als ausgehärtetes Harz und/oder Lackierung ausgeführt. Durch eine solche Deckschicht kann die Oberfläche des Möbelstücks versiegelt werden. In einer anderen bevorzugten Ausgestaltung kann die Deckschicht auch durch eine Kunststofffolie gebildet werden, die auf Teilen des Möbelstücks appliziert wird und diese schützt. Die Harze, Lacke oder Kunststofffolien sind vorzugsweise für sichtbares Licht durchlässig bzw. erscheinen transparent, so dass sowohl das Licht des Leuchtmittels als auch die ggf. hochwertige Holzfurnieroberfläche sichtbar bleibt.

Vorzugsweise ist das Fensterelement als ausgehärtetes Harz und/oder Lackierung ausgeführt. Dies bietet den Vorteil, dass es in einem Zuge zusammen mit dem Aufbringen der Deckschicht erzeugbar ist. So werden beispielsweise in eine als Holzfurnier ausgeführte Zwischenschicht die beschriebenen Ausfräsungen eingebracht, und anschließend wird das Holzfurnier mit der Deckschicht versehen.

Dabei wird ein Lack oder Harz auf das Furnier aufgetragen, welches anschließend aushärtet. Der Lack oder das Harz kann dabei in die Ausfräsungen hineinlaufen und anschließend in ihnen aushärten, um so das Fensterelement zu bilden. Alternativ kann das Fensterelement in einer anderen Ausführung auch als Kunststoffeinsatz ausgeführt sein und vor der Applikation des Lacks bzw. Harzes in die Ausfräsungen eingesetzt werden.

Vorzugsweise ist durch eine Betätigung des kapazitiven Schaltelements das Leuchtmittel an- oder ausschaltbar. Durch ein solches Einrichten der Bauteile bekommt der Nutzer eine sofortige Rückmeldung, wenn das kapazitive Schaltelement betätigt wird. Andere Möglichkeiten für eine entsprechende Rückmeldung können beispielsweise ein akustisches Signal und/oder eine mechanische Vibration im Bereich des elektronischen Schaltelements sein.

Vorzugsweise weist das Möbelstück einen Bildschirm auf und/oder ist mit einem Bildschirm verbindbar und weiterhin ist das kapazitive Schaltelement vorzugsweise zur Steuerung einer auf dem Bildschirm dargestellten Kabinenfunktion nutzbar.

Somit ist durch das kapazitive Schaltelement eine Bedienung der auf dem Bildschirm dargestellten Applikationen oder Kabinenfunktionen möglich. Beispielsweise kann so ggf. die Sitzstellung verstellt, Filme oder andere elektronische Unterhaltungsmedien ausgewählt und gestartet sowie die Lautstärke dieser Medien geregelt werden. Unter Applikationen sind in diesem Sinne bestimmte, in der Regel komplexere Kabinenfunktionen zu verstehen.

Eine solche Steuerung unterscheidet sich dabei deutlich von vorhandenen Steuerungen, da diese in der Regel über einen Sensorbildschirm erfolgen. Zwar kann eine solche Steuerung über Sensorbildschirme in manchen Anwendungen vorteilhaft sein, eine Trennung der Steuerung kann jedoch insbesondere bei Anwendungen, bei denen eine Sensorbildschirmeingabe aus ergonomischen Gründen schwierig oder unerwünscht ist, vorteilhaft sein.

Eine Integration der Steuerung in ein Möbelstück, beispielsweise in einen Sitz, ermöglicht es dem Fluggast ohne Anstrengungen die verschiedenen Kabinenfunktionen zu steuern, ohne dazu unmittelbar auf einen Bildschirm drücken zu müssen.

Im Falle einer Sitzverstellung durch verschiedene Servomotoren ist dies für den Nutzer vorteilhaft, da er auf diese Weise seine Sitzstellung verändern kann, ohne diese zum Bedienen eines Bildschirms verändern oder verlassen zu müssen. Vorzugsweise ist die Elektronik und/oder die Verkabelung bzw. Kabelführung in das Möbelstück bzw. in die Strukturteile des Möbelstücks integriert. Im Falle eines Tisches kann die Kabelführung beispielsweise in der Tischplatte und nicht unter der Tischplatte angeordnet sein.

Der Bildschirm kann einerseits in demselben ersten Möbelstück wie das kapazitive Schaltelement angeordnet sein, er kann jedoch auch in einem anderen, zweiten Möbelstück angeordnet sein, welches von dem ersten Möbelstück aus sichtbar ist.

Vorzugsweise ist das kapazitive Schaltelement so eingerichtet, dass eine translatorische Betätigungsbewegung zur Steuerung eines Schiebreglers nutzbar ist. Demnach ist das kapazitive Schaltelement vorzugsweise nicht auf eine binäre Informationseingabe bzw. -verarbeitung ("An-Aus" bzw. "1-0") beschränkt, sondern auch eine translatorische Betätigungsbewegung kann als eine solche erkannt und zur Steuerung eines Schiebreglers genutzt werden. Dadurch kann auf eine sonst übliche sprunghafte inkrementelle Regelung verzichtet werden.

Beispielsweise kann die Lautstärkeregelung der Unterhaltungsmedien durch eine Wisch- oder Schwenkbewegung gesteuert werden, ohne dass mehrfach auf einen einzelnen Schalter gedrückt werden muss.

Eine bevorzugte Möglichkeit, sowohl die Eingabe von Wisch- oder Schwenkbewegungen als auch die Eingabe einfacher Steuerungsbefehle zu ermöglichen, ist, das kapazitive Schaltelement so auszuführen, dass es mehrere kapazitive Schalter und/oder Sensorbereiche aufweist.

In einem anderen Ausführungsbeispiel ist das kapazitive Schaltelement so eingerichtet, dass neben einer translatorischen Betätigungsbewegung eine Betätigungsbewegung senkrecht dazu oder eine Kombination aus beiden Richtungen zur Steuerung nutzbar ist.

Beispielsweise werden drei Sensorbereiche vorgesehen, von denen zwei zum Starten und Beenden von Kabinenfunktionen und/oder Applikationen genutzt werden. Über einen weiteren Sensorbereich, in dem über eine translatorische Eingabebewegung zwischen verschiedenen Kabinenfunktionen und/oder Applikationen ausgewählt werden kann, ist beispielsweise die Lautstärkeregelung von bestimmten Applikationen und/oder Kabinenfunktionen möglich.

Die Sensorbereiche können örtlich voneinander getrennt und jeweils zum Detektieren von bestimmten Eingabearten eingerichtet sein. Beispielsweise kann ein Sensorbereich dazu eingerichtet sein, eine translatorische Betätigungsbewegung zu detektieren oder dazu eine einfache Druck- oder Tastbewegung zu detektieren.

Diese verschiedenen Sensorbereiche werden vorzugsweise durch eine Mehrzahl an kapazitiven Schaltelementen ausgebildet, die nebeneinander unter der Bauteiloberfläche angeordnet sind.

Die Kabelführung ist dabei vorzugsweise in das Möbelstück integriert, so dass das Möbelstück und die elektrischen Bestandteile eine bauliche Einheit bilden.

Die Erfindung wird im Folgenden anhand bevorzugter Ausführungsformen unter Bezugnahme auf die beigefügten Figuren erläutert. Dabei zeigt:
- Fig. 1: ein elektronisches Schaltelement in einer Möbeloberfläche nach dem Stand der Technik;
- Fig. 2: eine vorteilhafte Anordnung eines kapazitiven Schaltelements unter der Deckschicht;
- Fig. 3: eine Darstellung einer Steuerung einer Kabinenfunktion durch das kapazitive Schaltelement;
- Fig. 4: eine Darstellung einer weiteren Steuerungsmöglichkeit von Kabinenfunktionen durch das kapazitive Schaltelement.

In der Figur 1 ist ein elektronisches Schaltelement 1 dargestellt, welches in einer Möbelstückoberfläche 13 eingebaut ist. Die Seitenkanten 11 des elektronischen Schaltelementes 1 ragen aus der Möbelstückoberfläche 13 heraus. In diesem Ausführungsbeispiel handelt es sich um ein Möbelstück in einer hochwertigen Kabineneinrichtung eines sog. VIP-Flugzeugs.

Durch ein Betätigungsmittel 9, beispielsweise den Finger eines Fluggastes, kann das elektronische Schaltelement 1 geschaltet und bedient werden. Das elektronische Schaltelement 1 dient in dieser Ausführungsform zur Steuerung einer Kabinenbeleuchtung.

Zwischen den Seitenkanten 11 des elektronischen Schaltelements 1 und des Möbelstücks treten ein oder mehrere Spalte 12 auf. Auch wenn der oder die Spalte 12 durch das präzise Fertigen der Bauteile nur sehr schmal sind, könnten durch die Spalte 12 etwaige verschüttete Flüssigkeiten eindringen, die Schäden an dem Möbelstück und/oder dem elektronischen Schaltelement 1 verursachen können.

Zudem können sich um die Seitenkanten 11 Verschmutzungen anlagern, die verhältnismäßig schwer zu reinigen sind.

In der Figur 2 ist eine bevorzugte vorteilhafte Ausführungsform eines Möbelstücks mit elektronischem Schaltelement 1 dargestellt, wobei in der Figur 2 eine isometrische. Schnittansicht des Teilbereichs zu sehen ist, in dem das elektronische Schaltelement 1 angeordnet ist. Das elektronische Schaltelement 1 dient hier ebenfalls zur Steuerung einer Kabinenfunktion.

Das elektronische Schaltelement 1 ist innerhalb der Strukturschicht 2 angeordnet, die in diesem Ausführungsbeispiel als Wabenleichtbaukonstruktion ausgeführt ist. Eine solche Wabenleichtbaukonstruktion weist typischerweise eine Ober- und Unterschicht, die in Fig. 2 nicht dargestellt sind, auf. Das elektronische Schaltelement 1 ist somit von der Strukturschicht 2 umgeben, wobei oberhalb des elektronischen Schaltelements 1 ein Leuchtmittel 5 angeordnet ist, welches beispielsweise als Platine mit LED Beleuchtung ausgeführt sein kann.

Elektrische Anschlüsse 8 verbinden das elektronische Schaltelement 1 und das Leuchtmittel 5 mit der zu steuernden Kabinenfunktion bzw. einer die Kabinenfunktionen steuernden, nicht dargestellten Computereinheit. Die entsprechende Verkabelung bzw. Kabelführung verläuft im Bereich des Möbelstücks vorzugsweise in der Strukturschicht 2 oder einem anderen Strukturteil des Möbelstücks. Gleiches gilt vorteilhaft für gegebenenfalls vorgesehene weitere elektronische Komponenten.

Das Leuchtmittel 5 ist mit seiner Oberseite an der Strukturschicht 2 befestigt. In dem Kontaktbereich weist die Strukturschicht 2 Aussparungen 6 auf, in denen das vom Leuchtmittel 5 emittierte Licht nicht durch die Strukturschicht 2 abgeschirmt wird.

Oberhalb der Strukturschicht 2 ist eine Zwischenschicht 4 angeordnet. Diese ist vorzugsweise als Edelholzfurnier ausgeführt und weist im Bereich oberhalb der Aussparungen 6 bzw. des Leuchtmittels 5 ein Fensterelement 7 auf. Die Zwischenschicht 4 ist im Bereich des Fensterelements 7 unterbrochen. Vorzugsweise wird ein Bereich der Zwischenschicht 4 ausgefräst, worin später das Fensterelement 7 sitzt bzw. eingesetzt wird.

Das Fensterelement 7 hat dabei vorzugsweise eine ähnliche Form wie die darunterliegenden Aussparungen 6.

Oberhalb der Zwischenschicht 4 ist eine Deckschicht 3 angeordnet. Die Deckschicht 3 besteht in diesem Ausführungsbeispiel aus einer Versiegelung mit durchsichtigem, ausgehärtetem Kunstharz bzw. durchsichtigem Kunststoff.

Das Fensterelement 7 besteht in diesem Ausführungsbeispiel ebenfalls aus durchsichtigem, ausgehärtetem Harz und wird in einem Zuge zusammen mit der Deckschicht 3 hergestellt. Auf die Zwischenschicht 4 wird Harz appliziert, welches beim Aushärten auch das Fensterelement 7 bildet. Dieser Schritt wird üblicherweise durchgeführt, bevor die Zwischenschicht 4 auf der Strukturschicht 2 befestigt wird.

Durch dieses Verfahren ist das Fensterelement 7 exakt an die geometrische Form angepasst, die zuvor in die Zwischenschicht 4 gefräst wurde. In einer anderen Ausführungsform wird das Fensterelement 7 aus einem Einsatz, vorzugsweise aus einem Kunststoffeinsatz gebildet, der in die entsprechende Ausfräsung eingesetzt wird und an diese Form angepasst ist. Des Weiteren kann es in bestimmten Ausführungsformen möglich sein, die Deckschicht 3 nicht als ausgehärtetes Harz oder Lack, sondern als Kunststofffolie auszuführen, die beispielsweise auf das Möbelstück aufgeklebt wird.

Die geometrische Form des Fensterelements 7 ist dabei vorzugsweise so gewählt, dass sie die zu steuernde Kabinenfunktion erkennbar macht bzw. der Nutzer, beispielsweise der Fluggast, die Form mit der zu steuernden Kabinenfunktion assoziiert, wenn er die Form des Fensterelements wahrnimmt. Die Form kann dazu beispielsweise ein markantes Symbol umfassen oder auch Buchstaben umfassen, die die Kabinenfunktion benennen oder beschreiben.

Will der Nutzer die Kabinenbeleuchtung an- oder ausschalten, kann er durch das Annähern seines Fingers an das Symbol auf dem Möbelstück das kapazitive Schaltelement auslösen, welches anschließend ein entsprechendes Signal an die Kabinenbeleuchtung bzw. die die Kabinenbeleuchtung regelnde Computereinheit sendet.

Durch das vorteilhafte Anordnen des kapazitiven Schaltelements in der Strukturschicht 2 und unterhalb der Deckschicht 3, ist die Deckschicht 3 im Bereich des kapazitiven Schaltelements nicht unterbrochen. Die Deckschicht 3 überdeckt den gesamten Bereich der Möbelstückoberfläche 13 plan, es sind in dem Bereich des elektronischen Schaltelements 1 keine Spalte vorhanden, durch die ggf. Flüssigkeiten in das Möbelstück eindringen könnten.

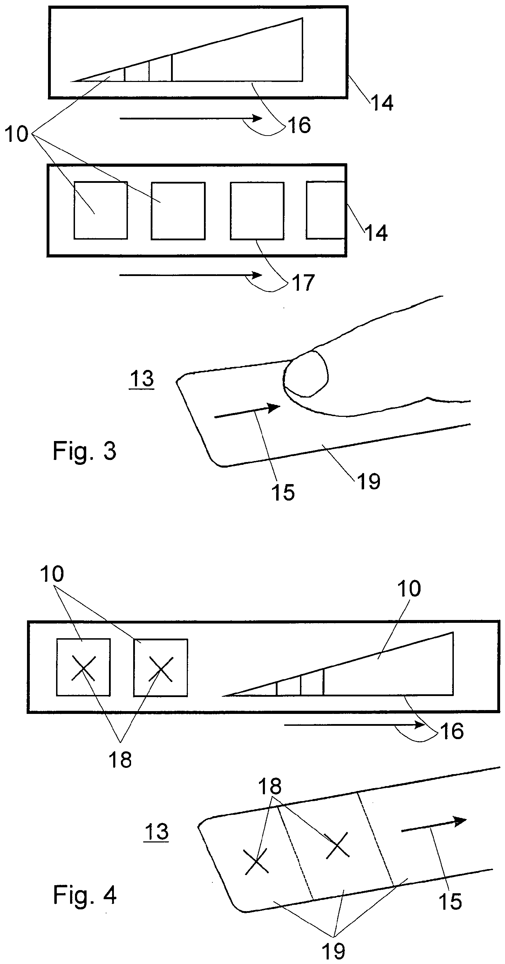

In der Figur 3 ist eine Möbelstückoberfläche 13 dargestellt, wobei der Sensorbereich 19 des darunterliegenden kapazitiven Schaltelements hervorgehoben ist.

Im oberen Bereich der Figur 3 sind zwei Bildschirme 14 dargestellt. Auf den Bildschirmen 14 sind Kabinenfunktionen 10 dargestellt, dabei kann es sich beispielsweise um Applikationen oder Regelungen handeln.

Im unteren Bildschirm 14 werden mehrere Applikationen nebeneinander angezeigt (die Applikationen bzw. der Startknopf der Applikationen ist durch Quadrate vereinfacht dargestellt). Im oberen Bildschirm 14 wird ein Schiebregler angezeigt. Durch eine translatorische Betätigungsbewegung 15 im Sensorbereich 19 können die auf den Bildschirmen 14 dargestellten Kabinenfunktionen gesteuert werden.

Im Beispiel des oberen Bildschirms kann beispielsweise eine Musiklautstärke durch eine Schiebregelung 16 geregelt werden. Je länger die translatorische Betätigungsbewegung 15 ausgeführt wird, umso lauter bzw. leiser wird die durch die Schiebregelung 16 geregelte Lautstärke.

Des Weiteren kann die translatorische Betätigungsbewegung 15 auch zur Menüführung genutzt werden, und somit beispielsweise eine Applikationsauswahl 17 realisiert werden, mit der aus den vorhandenen Applikationen die gewünschte ausgewählt werden kann.

Die Bildschirme 14 können in der näheren Umgebung des elektronischen Schaltelements, vorzugsweise in demselben Möbelstück vorgesehen sein. Beispielsweise kann der Bildschirm 14 senkrecht zur Bauteiloberfläche 13 im Bereich des kapazitiven Schaltelements angeordnet sein, wodurch er vom Betrachter gut gesehen werden kann.

In einer weiteren bevorzugten Ausgestaltung sind zwei Bildschirme 14 vorgesehen, wobei ein Bildschirm 14 unterhalb der Deckschicht 3 angeordnet ist und ein weiterer Bildschirm 14, vorzugsweise senkrecht dazu, an einer zweiten Position vorgesehen ist. Auf beiden Bildschirmen 14 kann dasselbe oder verschiedene Menüs dargestellt werden, so dass der Betrachter auf den Bildschirm 14 blicken kann, der aus seiner Position am besten sichtbar ist. Zusätzlich oder alternativ kann der Bildschirm 14 unterhalb der Deckschicht 3 dem Nutzer sofort eine Rückmeldung über etwaige Eingaben anzeigen bzw. geben.

In der Figur 4 ist eine weitere bevorzugte Ausgestaltung des elektronischen Schaltelements 1 dargestellt, welches unterhalb der Möbelstückoberfläche 13 angeordnet ist. Es weist hier drei Sensorbereiche 19 auf, wobei ein Sensorbereich 19, wie in der Figur 4, zur Detektion einer translatorischen Betätigungsbewegung 15, beispielsweise einer Wisch- oder Schwenkbewegung, eingerichtet ist. Die zwei weiteren Sensorbereiche 19 sind so eingerichtet, dass sie nur binär operieren. Sie sind demnach so eingerichtet, dass sie bei Betätigung nur ein einzelnes An- oder Aussignal senden.

Das elektronische Schaltelement 1 detektiert in den verschiedenen Sensorbereichen 19 die Betätigung eines Nutzers und stellt in einem zugehörigen Bildschirm 14 das Resultat dar. Beispielweise die Anpassung eines Sitzes durch verschiedene Einstellmöglichkeiten verschiedener Sitzkomponenten, die in verschiedenen Menüs vorgenommen werden kann, oder beispielsweise einer Lautstärkeregelung. Für beides ist eine Schiebregelung 16 geeignet und hilfreich.

Außerdem können Applikationen über die Applikationsbetätigungen 18 gestartet oder beendet werden. Dazu reicht beispielsweise ein einfaches Tippen auf den entsprechenden Sensorbereich 19 aus. Die Applikationsbetätigung 18 kann auch zur Menüführung genutzt werden, um beispielsweise zwischen verschiedenen Haupt- und/oder Untermenüs hin- und herzusteuern.

Zur Detektion einer translatorischen Betätigungsbewegung 15 umfasst das kapazitive Schaltelement vorzugsweise mehrere kapazitive Schalter, die nebeneinander angeordnet sind. Über eine entsprechende Programmierung können die von diesen mehreren Schaltern zeitlich versetzten Signale ausgewertet und als ein entsprechendes Betätigungssignal identifiziert und verwertet werden.

In einer bevorzugten Ausführungsform entspricht die Größe des oder der Sensorbereiche 19 ungefähr der Größe des oder der Bildschirme 14. Dadurch kann der Nutzer beides leicht miteinander assoziieren und die verhältnismäßig kleinen Bildschirme 14 können einfacher an Armlehnen oder ähnlich kleinen Flächen vorgesehen werden. Auch liegen die Sensorbereiche 19 in einer weiteren Ausführungsform vorzugsweise nicht nur in einer Ebene, sondern sie sind beispielsweise oben auf einer Armlehne und ebenfalls auf der Vorderkante derselben Armlehne vorgesehen.

### Bezugszeichenliste:

- 1: Elektronisches Schaltelement
- 2: Strukturschicht
- 3: Deckschicht
- 4: Zwischenschicht
- 5: Leuchtmittel
- 6: Aussparungen
- 7: Fensterelement
- 8: elektrische Anschlüsse
- 9: Betätigungsmittel
- 10: Kabinenfunktion
- 11: Seitenkanten
- 12: Spalt
- 13: Möbelstückoberfläche
- 14: Bildschirm
- 15: translatorische Betätigungsbewegung
- 16: Schiebregelung
- 17: Applikationsauswahl
- 18: Applikationsbetätigung
- 19: Sensorbereich

## Patentansprüche

1. Möbelstück mit einem elektronischen Schaltelement (1) zur Steuerung einer Kabinenfunktion (10) für ein Verkehrsflugzeug, wobei das Möbelstück eine Strukturschicht (2) und eine oberhalb der Strukturschicht (2) angeordnete lichtdurchlässige Deckschicht (3) aufweist, wobei die Deckschicht durchgängig und plan ausgeführt ist, wobei das elektronische Schaltelement (1) als kapazitives Schaltelement ausgeführt ist und unterhalb der Deckschicht (3) von der Strukturschicht (2) umgeben ist, wobei das Möbelstück ein Leuchtmittel (5) umfasst, welches oberhalb des kapazitiven Schaltelements und unterhalb der Deckschicht (3) angeordnet ist, wobei die Strukturschicht (2) oberhalb des Leuchtmittels (5) eine oder mehrere Aussparungen (6) aufweist.

2. Möbelstück nach Anspruch 1, **dadurch gekennzeichnet, dass** zwischen Strukturschicht (2) und Deckschicht (3) eine Zwischenschicht (4) angeordnet ist, welche vorzugsweise als Holzfurnier ausgeführt ist.

3. Möbelstück nach Anspruch 2, **dadurch gekennzeichnet, dass** die Zwischenschicht (4) ein Fensterelement (7) aufweist, welches zumindest teilweise für sichtbares Licht transparent ist und oberhalb der Aussparungen (6) der Strukturschicht (2) angeordnet ist.

4. Möbelstück nach Anspruch 2 oder 3, **dadurch gekennzeichnet, dass** die Aussparungen (6) und/oder das Fensterelement (7) eine der zu steuernden Kabinenfunktion (10) zuordenbare geometrische Form aufweisen.

5. Möbelstück nach Anspruch 4, **dadurch gekennzeichnet, dass** die Deckschicht (3) als ausgehärtetes Harz und/oder Lackierung ausgeführt ist.

6. Möbelstück nach Anspruch 4 oder 5, **dadurch gekennzeichnet, dass** das Fensterelement (7) als ausgehärtetes Harz und/oder Lackierung ausgeführt ist.

7. Möbelstück nach einem der vorangegangenen Ansprüche,
**dadurch gekennzeichnet, dass** durch eine Betätigung des kapazitiven Schaltelements das Leuchtmittel (5) an- oder ausschaltbar ist.

8. Möbelstück nach einem der vorangegangenen Ansprüche,
**dadurch gekennzeichnet, dass** es einen Bildschirm (14) aufweist und/oder mit einem Bildschirm (14) verbindbar ist und das kapazitive Schaltelement zur Steuerung einer auf dem Bildschirm (14) dargestellten Kabinenfunktion (10) nutzbar ist.

9. Möbelstück nach Anspruch 8, **dadurch gekennzeichnet, dass** das kapazitive Schaltelement so eingerichtet ist, dass eine translatorische Betätigungsbewegung (15) zur Steuerung eines Schiebreglers (16) nutzbar ist.

10. Möbelstück nach einem der vorangegangenen Ansprüche,
**dadurch gekennzeichnet, dass** das kapazitive Schaltelement mehrere kapazitive Schalter und/oder Sensorbereiche (19) aufweist.

11. Möbelstück nach einem der vorangehenden Ansprüche, **dadurch gekennzeichnet, dass** elektronische Komponenten und/oder die Verkabelung bzw. Kabelführung in das Möbelstück bzw. in ein Strukturteil des Möbelstücks integriert ist.

## Claims

1. Piece of furniture comprising an electronic switching element (1) for controlling a cabin function (10) for an airliner, the piece of furniture having a structural layer (2) and a translucent cover layer (3) arranged above the structural layer (2), wherein the cover layer is continuous and planar, wherein the electronic switching element (1) is in the form of a capacitive switching element and is surrounded by the structural layer (2) underneath the cover layer (3), wherein the piece of furniture comprises a lighting means (5) which is arranged above the capacitive switching element and underneath the cover layer (3), wherein the structural layer (2) above the lighting means (5) comprises one or more recesses (6).

2. Piece of furniture according to claim 1, **characterised in that** between the structural layer (2) and the cover layer (3) an intermediate layer (4) is arranged which is preferably in the form of a wooden veneer.

3. Piece of furniture according to claim 2, **characterised in that** the intermediate layer (4) comprises a window element (7) which is at least partly transparent to visible light and is arranged above the recesses (6) of the structural layer (2).

4. Piece of furniture according to claims 2 or 3, **characterised in that** the recesses (6) and/or the window element (7) have a geometric shape that can be assigned to the cabin function (10) to be controlled.

5. Piece of furniture according to claim 4, **characterised in that** the cover layer (3) is in the form of hardened resin and/or varnish.

6. Piece of furniture according to claim 4 or 5, **characterised in that** the window element (7) is in the form of hardened resin and/or varnish.

7. Piece of furniture according to any of the preceding claims, **characterised in that** the lighting means (5) can be switched on or off by actuating the capacitive switching element.

8. Piece of furniture according to any of the preceding claims, **characterised in that** it comprises a display (14) and/or can be connected to a display (14) and the capacitive switching element can be used for controlling a cabin function (10) represented on the display (14).

9. Piece of furniture according to claim 8, **characterised in that** the capacitive switching element is configured so that a translatory actuation movement (15) can be used for controlling a slide control (16).

10. Piece of furniture according to any of the preceding claims, **characterised in that** the capacitive switching element comprises a plurality of capacitive switches and/or sensor regions (19).

11. Piece of furniture according to any of the preceding claims, **characterised in that** electronic components and/or the cabling respectively cable guide into the piece of furniture respectively into a structural part of the piece of furniture is integrated.

## Revendications

1. Meuble comportant un élément de commutation électronique (1) commandant une fonction de cabine (10) pour avion de ligne, dans lequel le meuble comporte une couche structurelle (2) et une couche de revêtement (3) translucide agencée au-dessus de la couche structurelle (2), dans lequel la couche de revêtement est réalisée de manière continue et plane, dans lequel l'élément de commutation électronique (1) est réalisé comme élément de commutation capacitif et est entouré par la couche structurelle (2) en dessous de la couche de revêtement (3), dans lequel le meuble comprend une source lumineuse (5), lequel est agencé au-dessus de l'élément de commutation capacitif et en dessous de la couche de revêtement (3), dans lequel la couche structurelle (2) comporte une ou plusieurs échancrures (6) au-dessus de la source lumineuse (5).

2. Meuble selon la revendication 1, **caractérisé en ce qu'**une couche intermédiaire (4) est agencée entre la couche structurelle (2) et la couche de revêtement (3), laquelle est de préférence réalisée comme placage de bois.

3. Meuble selon la revendication 2, **caractérisé en ce que** la couche intermédiaire (4) comporte un élément de fenêtre (7), lequel est au moins partiellement transparent à la lumière visible et est agencé au-dessus des échancrures (6) de la couche structurelle (2).

4. Meuble selon la revendication 2 ou 3, **caractérisé en ce que** les échancrures (6) et/ou l'élément de fenêtre (7) comportent une forme géométrique pouvant être ordonnée à la fonction de cabine (10) à commander.

5. Meuble selon la revendication 4, **caractérisé en ce que** la couche de revêtement (3) est réalisée en résine durcie et/ou en vernis.

6. Meuble selon la revendication 4 ou 5, **caractérisé en ce que** l'élément de fenêtre (7) est réalisé en résine durcie et/ou en vernis.

7. Meuble selon l'une des revendications précédentes, **caractérisé en ce que** la source lumineuse (5) peut être allumée ou éteinte par un actionnement de l'élément de commutation capacitif.

8. Meuble selon l'une des revendications précédentes, **caractérisé en ce qu'**il comporte un écran (14) et/ou peut être relié à un écran (14) et l'élément de commutation capacitif est utilisable pour commander une fonction de cabine (10) représentée sur l'écran (14).

9. Meuble selon la revendication 8, **caractérisé en ce que** l'élément de commutation capacitif est configuré de sorte qu'un mouvement d'actionnement translatoire (15) est utilisable pour commander un curseur de réglage (16).

10. Meuble selon l'une des revendications précédentes, **caractérisé en ce que** l'élément de commutation capacitif comporte plusieurs commutateurs capacitifs et/ou zones de capteur (19).

11. Meuble selon l'une des revendications précédentes, **caractérisé en ce que** les composants électroniques et/ou le câblage ou chemin de câble sont intégrés dans le meuble ou dans une pièce structurelle du meuble.
